# EUROPÄISCHE PATENTANMELDUNG

(11) **EP 1 137 178 A1**
(43) Veröffentlichungstag der Anmeldung: **26.09.2001**
(21) Anmeldenummer: 00106267.8
(22) Anmeldetag: 22.03.2000
(51) Int. Cl.: H03J 3/04, H03J 7/04

(54) **Schaltungsanordnung mit einem Filter und Verfahren zum Betrieb einer Schaltungsanordnung mit einem Filter**

(71) Anmelder: Infineon Technologies AG, 81669 München (DE)
(72) Erfinder: Hofmann, Andreas, 82041 Oberhaching (DE)
(74) Vertreter: Fischer, Volker, Dipl.-Ing.

(57) **Zusammenfassung**

Es ist eine Schaltungsanordnung mit einem Filter, beispielsweise einem Bandpaß-Filter, sowie ein Verfahren zu deren Betrieb angegeben, welche die Kompensation einer Frequenzabweichung (ΔF), beispielsweise einer tatsächlichen Mittenfrequenz von einer Sollfrequenz (FO) ermöglicht. Es ist ein dem Filter (FI) vorgeschalteter erster Mischer (MI1), sowie ein dem Filter (FI) nachgeschalteter zweiter Mischer (MI2) vorgesehen, denen jeweils an einem Eingang ein Signal mit einer Oszillationsfrequenz (LO1, LO2) zugeführt wird. Die Oszillationsfrequenzen (LO1 LO2) werden in Abhängigkeit von der Frequenzabweichung in Frequenzgeneratoren (PLL1, PLL2) so gemischt, daß das Signal mit der Zwischenfrequenz (ZF) an die Filtercharakteristik des toleranzbehafteten Filters (FI) angepaßt ist. Hierdurch können Filter (FI), die den hohen Anforderungen von WCDMA-Mobilfunk-Anwendungen genügen, aber eine fertigungsbedingt zu hohe Mittenfrequenz-Abweichung aufweisen, beispielsweise in Heterodyn-Empfängern eingesetzt werden.

## Beschreibung

Schaltungsanordnung mit einem Filter und Verfahren zum Betrieb einer Schaltungsanordnung mit einem Filter

Die Erfindung betrifft eine Schaltungsanordnung mit einem Filter und mit Mischern sowie ein Verfahren zum Betrieb einer Schaltungsanordnung mit einem Filter und mit Mischern.

In der Hochfrequenz-Technik, beispielsweise in Anwendungen des Mobilfunks, werden Filter, beispielsweise Bandpaß-Filter, als Zwischenfrequenz-Filter eingesetzt. Die Zwischenfrequenz ist dabei eine üblicherweise feste Frequenz, welche zwischen den Sende- und Empfangsfrequenzen und dem Basisband oder oberhalb der Sende- und Empfangsfrequenzen liegen kann. An solche Bandpaß-Filter werden hohe Anforderungen bezüglich einer niedrigen Einfügedämpfung beziehungsweise einer geringen Durchgangsdämpfung gestellt. Außerdem sind geringe Ein- und Ausgangs-Impedanzen der Filter gefordert, um eine möglichst gute Anpassung der Filter an vorausgehende sowie nachfolgende Schaltungen zu gewährleisten. Bei modernen, leistungsfähigen Mobilfunk-Verfahren wie UMTS (Universal Mobile Telecommunications System), beziehungsweise WCDMA (Wide-Band Code Division Multiple Access) sind die Anforderungen an Durchgangsdämpfung sowie Ein- und Ausgangs-Impedanzen von Filtern, beispielsweise Bandpaß-Filtern, besonders hoch.

Gute Eigenschaften bezüglich Einfügedämpfung und Impedanzen haben Filter, welche beispielsweise auf Lithium-Tantalat-Substrat realisiert sind. Diese Technologie weist jedoch den Nachteil vergleichsweise hoher Fertigungs-Toleranzen auf. Außerdem haben Schaltungen beziehungsweise Bauteile, welche auf Lithium-Tantalat-Technologie aufgebaut sind, eine relativ hohe Temperaturdrift bezüglich der signifikanten Frequenzen, wie beispielsweise der Mittenfrequenz bei Bandpaß-Filtern oder den 3dB-Grenzfrequenzen.

Quarzfilter, beispielsweise Bandpaß-Filter, haben geringe Fertigungstoleranzen bezüglich der Mittenfrequenz, sowie geringe Temperaturdrift der Mittenfrequenz. Quarzfilter haben jedoch eine nachteilhafte, hohe Einfüge- beziehungsweise Durchgangsdämpfung, sowie hohe Ein- und Ausgangs-Impedanzen. Mit zusätzlichen Verstärkerstufen, beziehungsweise mit zusätzlichen Anpass-Elementen, welche geringe Toleranzen aufweisen müssen, können die Nachteile der Quarzfilter ausgeglichen werden. Zusätzliche Verstärkerstufen führen aber zu einem größeren Stromverbrauch, verursachen zusätzliche Kosten und benötigen zusätzliche Fläche zur Realisierung. Zusätzliche Anpass-Elemente verursachen ebenfalls höhere Kosten, beziehungsweise führen zu größerem Platzbedarf. In der Mobilfunk-Technik sind die Reduzierung von Stromverbrauch, Platzbedarf sowie der Kosten wichtige Entwicklungsziele.

Der vorliegenden Erfindung liegt die Aufgabe zugrunde, eine Schaltungsanordnung mit einem Filter sowie ein Verfahren zum Betrieb einer Schaltungsanordnung mit einem Filter zur Kompensation von Filtertoleranzen anzugeben.

Bezüglich der Schaltungsanordnung wird die Aufgabe gelöst von einer Schaltungsanordnung, aufweisend einen ersten Mischer, mit einem ersten und einem zweiten Eingang und einem Ausgang; ein Filter mit einem Filtereingang, der an den Ausgang des ersten Mischers angeschlossen ist, und mit einem Filterausgang, wobei das Filter eine Frequenzabweichung einer charakteristischen Frequenz von einer Sollfrequenz hat; einen zweiten Mischer, der mit einem ersten Eingang an den Filterausgang angeschlossen ist und der einen zweiten Eingang und einen Ausgang hat; einen ersten Frequenzgenerator, dem ein Signal, welches die Frequenzabweichung repräsentiert, zuführbar ist, und der an den zweiten Eingang des ersten Mischers angeschlossen ist; und einen zweiten Frequenzgenerator, dem ein Signal, welches die Frequenzabweichung repräsentiert, zuführbar ist, und der an den zweiten Eingang des zweiten Mischers angeschlossen ist.

Bezüglich des Verfahrens wird die Aufgabe gelöst von einem Verfahren zum Betrieb einer Schaltungsanordnung mit einem Filter mit folgenden Verfahrensschritten: Mischen eines Signals mit einer Empfangsfrequenz mit einem Signal mit einer ersten Oszillationsfrequenz in einem ersten Mischer unter Bildung eines Zwischenfrequenz-Signals; Filtern des Zwischenfrequenz-Signals in einem Filter, das eine Frequenzabweichung einer charakteristischen Frequenz von einer Sollfrequenz hat; Mischen des gefilterten Zwischenfrequenz-Signals mit einem Signal mit einer zweiten Oszillationsfrequenz in einem zweiten Mischer; Zuführen eines Signals, welches die Frequenzabweichung repräsentiert, an einen ersten Frequenzgenerator, der das Signal mit der ersten Oszillationsfrequenz erzeugt, und an einen zweiten Frequenzgenerator, der das Signal mit der zweiten Oszillationsfrequenz erzeugt.

Das Filter ist zwischen einem ersten Mischer und einem zweiten Mischer angeordnet. Hierfür ist der Filtereingang mit dem Ausgang des ersten Mischers verbunden. Der Filterausgang ist mit einem ersten Eingang des zweiten Mischers verbunden. Der erste und der zweite Mischer mischen ein erstes Eingangssignal mit einem an einem zweiten Eingang anliegenden Signal, wobei letzteres jeweils in einem Frequenzgenerator erzeugt ist. Das Filter weist eine Frequenzabweichung von einer Soll-frequenz auf. Diese Frequenzabweichung ist dem ersten und zweiten Frequenzgenerator zuführbar. Die Frequenzen des vom ersten beziehungsweise zweiten Frequenzgenerator erzeugbaren Signals hängen von der Frequenzabweichung des Filters ab. Hierdurch kann das dem Filter zuführbare Zwischenfrequenz-Signal, welches am Ausgang des ersten Mischers anliegt, der bekannten Frequenzabweichung des Filters angepaßt werden.

Das beschriebene Prinzip der Anpassung des dem Filter zuführbaren Signals an eine bekannte Frequenzabweichung des Filters mittels der beschriebenen Anordnung mit zwei Frequenzgeneratoren und zwei Mischern ermöglicht es, Filter einzusetzen, welche eine geringe Durchgangsdämpfung sowie geringe Ein- und Ausgangs-Impedanzen aufweisen, aber Fertigungstoleranzen sowie Temperaturdrift unterworfen sind, welche zu Frequenzabweichungen führen können. Dies ist beispielsweise bei Filtern mit Lithium-Tantalat-Substrat gegeben. Das beschriebene Prinzip kombiniert die Vorteile der geringen Durchgangsdämpfung, der geringen Ein- und Ausgangs-Impedanzen, sowie der Toleranzkompensation von fertigungs- oder temperaturbedingten Frequenzabweichungen. Hierdurch sind keine zusätzlichen Verstärkerstufen, welche zusätzlichen Stromverbrauch, zusätzliche Kosten sowie zusätzliche Chipfläche bedeuten, erforderlich. Die beschriebene Anordnung ist besonders gut für Empfänger-Architekturen von WCDMA-Heterodyn-Empfängern geeignet, da hierbei der geringen Durchgangsdämpfung, der geringen Ein- und Ausgangs-Impedanz sowie dem Einhalten der systembedingten Durchlaß- und Sperr-Frequenzanforderungen genügt wird. Die beschriebenen Frequenzgeneratoren sowie die beiden Mischer sind in solchen Systemen bereits vorhanden. Die Frequenzgeneratoren solcher Systeme weisen ohnehin Eingänge auf, mit denen die Frequenzen der generierbaren Ausgangssignale einstellbar beziehungsweise verstimmbar sind.

In einer vorteilhaften Ausführung der vorliegenden Erfindung ist die Frequenz des vom erstem Frequenzgenerator generierbaren Signals gleich der Empfangsfrequenz des am erstem Eingang des ersten Mischers anliegenden Signals plus der Sollfrequenz des Filters plus der Frequenzabweichung des Filters.

In einer gleichwertigen vorteilhaften Ausführungsform der vorliegenden Erfindung ist die Frequenz des vom erstem Frequenzgenerators generierbaren Signals gleich der Empfangsfrequenz des am erstem Eingang des ersten Mischers anliegenden Empfangssignals minus der Sollfrequenz des Filters minus der Frequenzabweichung des Filters.

In einer vorteilhaften Ausführungsform der vorliegenden Erfindung ist die Frequenz des vom zweitem Frequenzgenerators generierbaren Signals gleich der Sollfrequenz des Filters plus der Frequenzabweichung des Filters. Hierdurch ist eine genaue Anpassung des zu filternden Signals an die Filtercharakteristik beziehungsweise die Durchlaß- und Sperr-Frequenzen des toleranzbehafteten Filters mit der Frequenzabweichung ΔF gegeben.

In einer weiteren vorteilhaften Ausführungsform der vorliegenden Erfindung ist das Filter ein Bandpaß-Filter, wobei die Frequenzabweichung ΔF die Abweichung der tatsächlichen Mittenfrequenz des Bandpaß-Filters von seiner Soll-Mittenfrequenz ist.

In einer weiteren vorteilhaften Ausführungsform der vorliegenden Erfindung weist das Filter, welches beispielsweise ein SAW (Surface Acoustic Wave)-Filter sein kann, ein Lithium-Tantalat-Substrat oder ein anderes keramisches Substrat mit piezoelektrischen Eigenschaften auf.

Das Verfahren zum Betrieb der Schaltungsanordnung mit einem Filter, welcher eine Frequenzabweichung von einer Sollfrequenz hat, weist einen ersten Verfahrensschritt auf, bei dem ein Signal mit einer Empfangsfrequenz in einem ersten Mischer mit einem Signal mit einer ersten Oszillationsfrequenz unter Bildung eines Zwischenfrequenz-Signals gemischt wird. Das Zwischenfrequenz-Signal wird in einem ersten Filter, welcher einer Frequenzabweichung von einer Sollfrequenz aufweist, gefiltert. In einem zweiten Mischer wird das gefilterte Zwischenfrequenz-Signal mit einem Signal mit einer zweiten Oszillationsfrequenz gemischt. Am Ausgang des zweiten Mischers kann ein Ausgangssignal abgeleitet werden. Die bekannte Frequenzabweichung des Filters wird den Eingängen eines ersten und eines zweiten Frequenzgenerators zugeführt. Abhängig von dieser Frequenzabweichung wird in den Frequenzgeneratoren eine erste beziehungsweise eine zweite Oszillationsfrequenz erzeugt. Diese wird den den Frequenzgeneratoren zugeordneten Mischern zugeführt. Dieses Verfahren erlaubt die Anpassung des Zwischenfrequenz-Signals bezüglich seiner Frequenzcharakteristik an die Filtercharakteristik des Filters.

In einer vorteilhaften Weiterbildung der vorliegenden Erfindung wird die Frequenz des Ausgangssignals des ersten Frequenzgenerators nach der Gleichung erste Oszillationsfrequenz gleich Empfangsfrequenz plus Sollfrequenz des Filters plus Frequenzabweichung des Filters oder erste Oszillationsfrequenz gleich Empfangsfrequenz minus Sollfrequenz des Filters minus Frequenzabweichung des Filters gebildet und das Signal mit einer zweiten Oszillationsfrequenz nach der Gleichung zweite Oszillationsfrequenz gleich Sollfrequenz des Filters plus Frequenzabweichung des Filters gebildet.

Die Frequenzabweichung des Filters kann aus einer ersten, fertigungsbedingten Frequenzabweichung und einer zweiten, temperaturbedingten Frequenzabweichung zusammengesetzt sein. Die Frequenzabweichung des Filters ergibt sich durch Addition der fertigungs- beziehungsweise temperaturbedingten Frequenzabweichungen des Filters. Der fertigungsbedingte Anteil der Frequenzabweichung des Filters kann beispielsweise dadurch ermittelt werden, daß die Sperr- beziehungsweise Durchgangs-Kennlinie des Filters gemessen wird. Dies kann in einer vorteilhaften Ausführungsform des beschriebenen Verfahrens dadurch geschehen, daß am ersten Eingang des ersten Mischers sukzessive Signale mit einer jeweils bekannten Frequenz nacheinander angelegt werden, und am Ausgang des zweiten Mischers die Amplitude bei der jeweiligen Frequenz am Ausgang des zweiten Mischers ableitbaren Signale gemessen werden. Der temperaturbedingte Anteil der Frequenzabweichung des Filters kann beispielsweise durch Messen der Umgebungstemperatur in einem Temperatursensor, Zuführen eines der Temperatur zugeordneten Signals vom Temperatursensor an einen Mikroprozessor, und Umrechnen der tatsächlichen Umgebungstemperatur in eine unter Berücksichtigung von materialabhängigen Temperaturkoeffizienten bekannte, von der Temperatur abhängige Frequenzabweichung in einem Mikroprozessor erfolgen. Dabei ist zu berücksichtigen, daß die erste, fertigungsbedingte Frequenzabweichung bei einer bekannten Normtemperatur durchgeführt wird, und die Temperaturabweichung von dieser Normtemperatur in eine zweite Frequenzabweichung umberechnet wird. In diesem Fall ist die tatsächliche, zu kompensierende Frequenzabweichung gleich der Summe der fertigungsbedingten Frequenzabweichung und der temperaturbedingten Frequenzabweichung.

Weitere Einzelheiten und Ausgestaltungen der Erfindung sind in den Unteransprüchen angegeben.

Die Erfindung wird nachfolgend an einem Ausführungsbeispiel anhand der Zeichnungen näher erläutert.

Es zeigen:
- Figur 1: ein prinzipielles Blockschaltbild einer Ausführungsform der vorliegenden Erfindung,
- Figur 2: ein Blockschaltbild zur Kompensation der temperaturabhängigen Frequenzabweichung.

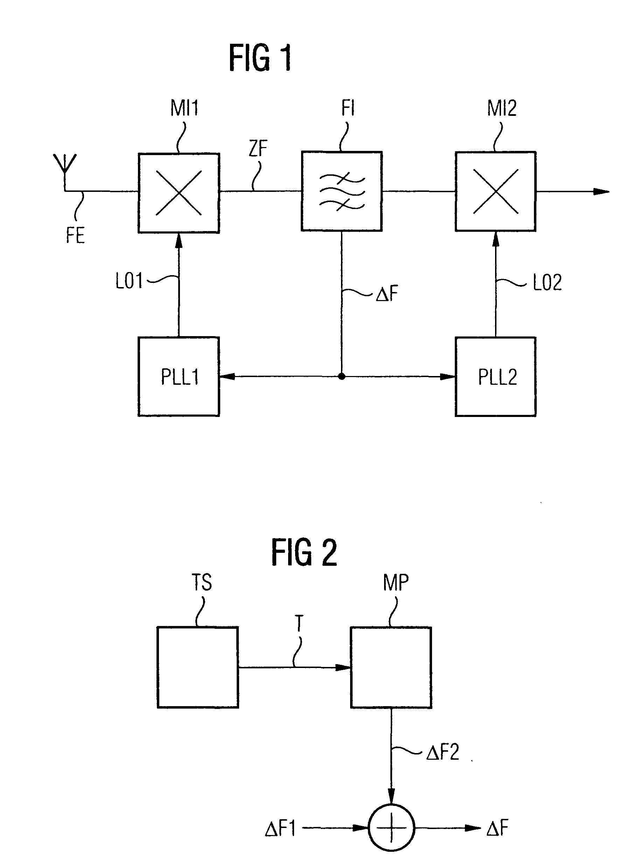

Figur 1 zeigt ein Ausführungsbeispiel der vorliegenden Erfindung anhand des Empfangspfades in einem Mobilfunk-Empfänger. An einem ersten Mischer MI1 ist an einem ersten Eingang ein Signal mit einer Empfangsfrequenz FE zuführbar. Hierfür kann der erste Eingang des ersten Mischers beispielsweise an eine Sende- und Empfangsantenne angeschlossen sein. An einem zweiten Eingang des ersten Mischers MI1 ist ein Signal mit einer ersten Oszillationsfrequenz LO1 zuführbar. Am Ausgang des ersten Mischers MI1, welcher im vorliegenden Fall ein Abwärtsmischer ist, ist ein Signal mit einer Zwischenfrequenz ZF ableitbar. Der Ausgang des ersten Mischers ist an den Eingang eines Filters F1 angeschlossen. Im Ausführungsbeispiel ist dieses Filter F1 ein Bandpaß-Filter. Der Ausgang des Filters F1 ist an einen ersten Eingang eines zweiten Mischers MI2 angeschlossen. Dem ersten Eingang des zweiten Mischers ist somit ein gefiltertes Zwischenfrequenz-Signal zuführbar. An einem zweiten Eingang des zweiten Mischers MI2 ist ein Signal mit einer zweiten Oszillationsfrequenz LO2 zuführbar. Am Ausgang des zweiten Mischers MI2, welcher im Ausführungsbeispiel ebenfalls ein Abwärtsmischer ist, steht ein Basisband-Signal zur Verfügung, welches beispielsweise einem Basisband-Baustein zuführbar ist. Das Filter FI weist eine Frequenzabweichung ΔF von einer Sollfrequenz FO auf. Da es sich um ein Bandpaß-Filter handelt, kann diese Sollfrequenz FO die Soll-Mittenfrequenz des Bandpaß-Filters sein. Die Frequenzabweichung ΔF ist daher die Frequenzabweichung ΔF der tatsächlichen Mittenfrequenz des Filters von der Soll-Mittenfrequenz FO des Filters FI, beziehungsweise deren Differenz. Die Frequenzabweichung ΔF des Filters FI ist den Eingängen eines ersten sowie eines zweiten Frequenzgenerators PLL1, PLL2 zuführbar. Diese Frequenzgeneratoren können beispielsweise PLL (Phase Locked Loop) - Synthesizer sein. Der Ausgang des ersten Frequenzgenerators PLL1 ist mit dem zweiten Eingang des Mischers MI1 verbunden, der Ausgang des zweiten Frequenzgenerators ist mit dem zweiten Eingang des zweiten Mischers MI2 verbunden. Die beiden Frequenzgeneratoren PLL1, PLL2 dienen der Erzeugung je eines Signals mit einer ersten und einer zweiten Oszillationsfrequenz LO1, LO2.

Der erste Mischer MI1 mischt das Signal mit der Empfangsfrequenz FE, welche beispielsweise 2100 Megahertz beträgt, mit einer ersten Oszillationsfrequenz LO1, welche zirka 2400 Megahertz beträgt. Der Abwärtsmischer MI1 bildet die Differenz der Signalfrequenzen, somit weist das Ausgangssignal des ersten Mischers eine Zwischenfrequenz ZF von zirka 300 Megahertz auf. Die Soll-Mittenfrequenz FO des Filters FI, welcher ein Bandpaß-Filter ist, beträgt demnach 300 Megahertz. Das Bandpaß-Filter FI filtert das Nutzsignal aus dem Zwischenfrequenz-Signal ZF heraus. Dieses gefilterte Zwischenfrequenz-Signal wird einem ersten Eingang eines zweiten Mischers MI2 zugeführt, wo es mit einem Signal mit einer zweiten Oszillationsfrequenz LO2 gemischt wird. Diese zweite Oszillationsfrequenz LO2 beträgt im Beispiel 300 Megahertz, so daß am Ausgang des zweiten Mischers MI2 die Trägerfrequenz des Basisbandsignals 0 Megahertz beträgt. Wenn nun das Filter FI, beispielsweise fertigungs- oder temperaturbedingt eine Frequenzabweichung ΔF seiner tatsächlichen Mittenfrequenz von einer Sollfrequenz FO aufweist, welche beispielsweise 0,2 Megahertz beträgt, so ist vorgesehen, daß in den Frequenzgeneratoren PLL1, PLL2 die Signale mit den Oszillationsfrequenzen LO1, LO2 so angepaßt werden, daß der Frequenzgang des Zwischenfrequenz-Signals an die tatsächliche Mittenfrequenz des Filters FI angepaßt ist. Hierfür wird die beispielhafte Frequenzabweichung von 0,2 Megahertz, welche sich aus der Differenz ΔF der tatsächlichen Mittenfrequenz und der Soll-Mittenfrequenz FO des Filters FI ergibt, dem ersten und dem zweiten Frequenzgenerator PLL1, PLL2 zugeführt. Im ersten Frequenzgenerator PLL1 wird die erste Oszillationsfrequenz LO1 aus Empfangsfrequenz FE plus Soll-Mittenfrequenz FO plus Frequenzabweichung ΔF berechnet. Dies ergibt eine erste Oszillationsfrequenz LO1 gleich 2100 Megahertz plus 300 Megahertz plus 0,2 Megahertz ist gleich 2400,2 Megahertz. Im ersten Mischer wird das Signal mit der ersten Oszillationsfrequenz LO1 von 2400,2 Megahertz mit dem Signal mit der Empfangsfrequenz von 2100 Megahertz gemischt, so daß die Frequenz des Zwischenfrequenz-Signals am Ausgang des ersten Mischers 300,2 Megahertz beträgt. Somit ist das Zwischenfrequenz-Signal an die Mittenfrequenz des Filters FI, welche tatsächlich 300,2 Megahertz beträgt, angepaßt. Diese absichtliche Verschiebung der Zwischenfrequenz muß jedoch wieder kompensiert werden. Hierzu wird im zweiten Frequenzgenerator PLL2 ein Signal mit einer zweiten Oszillationsfrequenz LO2 gleich Soll-Frequenz FO plus Frequenzabweichung ΔF des Filters FI gebildet. Im Beispiel ist LO2 gleich FO plus ΔF gleich 300 plus 0,2 Megahertz. Da an beiden Eingängen des zweiten Mischers MI2 Signale mit Frequenzen von 300,2 Megahertz anliegen, ist die Trägerfrequenz des Ausgangssignals 0 Megahertz und somit in einem Basisband-Baustein zur weiteren Verarbeitung geeignet. Da Mischer Differenzen der Eingangssignal-Frequenzen bilden, ist alternativ die erste Oszillationsfrequenz LO1 nach der Gleichung LO1 gleich FE minus FO minus ΔF bestimmbar, im Beispiel gilt LO1 gleich 2100 Megahertz minus 300 Megahertz minus 0,2 Megahertz ist gleich 1799,8 Megahertz. Mischen der ersten Oszillationsfrequenz LO1 mit der Empfangsfrequenz FE gleich 2100 Megahertz ergibt wiederum ein Zwischenfrequenz-Signal mit einer Zwischenfrequenz von 300,2 Megahertz.

Zur Gewinnung der Frequenzabweichung ΔF, welche beispielsweise eine fertigungsbedingte Komponente und eine temperaturbedingte Komponente aufweisen kann, ist in Figur 2 ein Blockschaltbild angegeben. Die erste, fertigungsbedingte Frequenzabweichung ΔF1 wird in einem Summierknoten mit der zweiten, temperaturbedingten Frequenzabweichung addiert, wobei als Summe die tatsächliche Frequenzabweichung ΔF bildbar ist. Die fertigungsbedingte Frequenzabweichung ΔF1 kann durch Ausmessen der Frequenz-Kennlinie beziehungsweise der Sperr- und Durchgangs-Kennlinie des Filters FI ermittelt werden. Hierfür kann an einem Eingang des ersten Mischers MI1 ein Signal veränderbarer Frequenz eingespeist werden, und am Ausgang des zweiten Mischers kann das Amplitudenspektrum dieses eingespeisten Signals analysiert werden. Ermitteln der oberen und unteren 3dB-Grenzfrequenzen ermöglicht die Berechnung der tatsächlichen Mittenfrequenz des Filters FI. In einfacher Weise kann die Erzeugung der Meß-Frequenzen im ersten Frequenzgenerator PLL1 erfolgen, welcher beispielsweise in Schritten von 200 Kilohertz verstimmbar ist. Sofern die Messung der fertigungsbedingten Frequenzabweichung ΔF1 des Filters FI bei einer festgelegten Temperatur, beispielsweise Normtemperatur, erfolgt, so kann in einfacher Weise die temperaturbedingte Frequenzabweichung ΔF2 des Filters FI ermittelt werden. Denn die Temperaturabhängigkeit der Mittenfrequenz eines Filters ist a priori bekannt. Wie in Figur 2 dargestellt, ist zur Erfassung der Umgebungstemperatur des Filters FI ein Temperatursensor TS vorgesehen, welcher der Umgebungstemperatur ein Temperatursignal T zuordnet, und dieses einem Mikroprozessor MP zuführt. Der Mikroprozessor MP, in dem die Abhängigkeit der Mittenfrequenz des Filters FI von der Temperatur hinterlegt ist, ordnet dem Temperatursignal T unter Berücksichtigung der Differenz der tatsächlichen Umgebungstemperatur von der Normtemperatur eine zweite Frequenzabweichung ΔF2 zu. Diese wird in einem Summierknoten mit der fertigungsbedingten Frequenzabweichung ΔF1 zu einer Frequenzabweichung ΔF addiert.

In Empfangspfaden von Mobilfunksystemen, beispielsweise nach UMTS, sind ohnehin Frequenzgeneratoren mit einstellbaren Ausgangs-Signalfrequenzen LO1, LO2 vorhanden. Daher ist die Erzeugung einer Oszillationsfrequenz, welche von einer Frequenzabweichung ΔF abhängt, in einfacher Weise realisierbar.

Das beschriebene Prinzip ist in angepaßter Form beispielsweise auch in Sendepfaden, in denen Filter vorhanden sind, welche Toleranzen unterworfen sind, anwendbar.

## Patentansprüche

1. Schaltungsanordnung, aufweisend
- einen ersten Mischer (MI1), mit einem ersten und einem zweiten Eingang und einem Ausgang,
- ein Filter (FI) mit einem Filtereingang, der an den Ausgang des ersten Mischers (MI1) angeschlossen ist, und mit einem Filterausgang, wobei das Filter eine Frequenzabweichung (ΔF) einer charakteristischen Frequenz von einer Sollfrequenz (FO) hat,
- einen zweiten Mischer (MI2), der mit einem ersten Eingang an den Filterausgang angeschlossen ist und der einen zweiten Eingang und einen Ausgang hat,
- einen ersten Frequenzgenerator (PLL1), dem ein Signal, welches die Frequenzabweichung (ΔF) repräsentiert, zuführbar ist, und der an den zweiten Eingang des ersten Mischers (MI1) angeschlossen ist, und
- einen zweiten Frequenzgenerator (PLL2), dem ein Signal, welches die Frequenzabweichung (ΔF) repräsentiert, zuführbar ist, und der an den zweiten Eingang des zweiten Mischers (MI2) angeschlossen ist.

2. Schaltungsanordnung nach Anspruch 1,
**dadurch gekennzeichnet, daß**
eine erste Oszillationsfrequenz (LO1) des vom ersten Frequenzgenerator (PLL1) generierbaren Signals gleich einer Empfangsfrequenz (FE) des am ersten Eingang des ersten Mischers (MI1) zuführbaren Empfangssignals plus der Sollfrequenz (FO) plus der Frequenzabweichung (ΔF) des Filters (FI) ist.

3. Schaltungsanordnung nach Anspruch 1,
**dadurch gekennzeichnet, daß**
eine erste Oszillationsfrequenz (LO1) des vom ersten Frequenzgenerators (PLL1) generierbaren Signals gleich einer Empfangsfrequenz (FE) des am ersten Eingang des ersten Mischers (MI1) zuführbaren Empfangssignals minus der Sollfrequenz (FO) minus der Frequenzabweichung (ΔF) des Filters (FI) ist.

4. Schaltungsanordnung nach Anspruch 2 oder 3,
**dadurch gekennzeichnet, daß**
eine zweite Oszillationsfrequenz (LO2) des vom zweiten Frequenzgenerator (PLL2) generierbaren Signals gleich der Soll-frequenz (FO) plus der Frequenzabweichung (ΔF) ist.

5. Schaltungsanordnung nach einem der Ansprüche 1 bis 4,
**dadurch gekennzeichnet, daß**
das Filter (FI) ein Bandpaß-Filter ist, und daß die Frequenzabweichung (ΔF) die Differenz von tatsächlicher Mittenfrequenz des Bandpaß-Filters (FI) und Soll-Mittenfrequenz (FO) des Bandpaß-Filters (FI) ist.

6. Schaltungsanordnung nach einem der Ansprüche 1 bis 4,
**dadurch gekennzeichnet, daß**
das Filter (FI) ein Hochpaß-Filter oder ein Tiefpaß-Filter ist, und daß die Frequenzabweichung (ΔF) die Abweichung der tatsächlichen 3dB-Grenzfrequenz von der Soll-3dB-Grenzfrequenz des Filters ist.

7. Schaltungsanordnung nach einem der Ansprüche 1 bis 4,
**dadurch gekennzeichnet, daß**
das Filter (FI) eine Bandsperre ist, und daß die Frequenzabweichung (ΔF) die Abweichung der tatsächlichen Resonanzfrequenz von der Soll-Resonanzfrequenz des Filters ist.

8. Schaltungsanordnung nach einem der Ansprüche 1 bis 7,
**dadurch gekennzeichnet, daß**
die Frequenzabweichung (ΔF) die Summe aus einer fertigungsbedingten Frequenzabweichung (ΔF1) und einer temperaturabhängigen Frequenzabweichung (ΔF2) ist.

9. Schaltungsanordnung nach einem der Ansprüche 1 bis 8,
**dadurch gekennzeichnet, daß**
das Filter (FI) ein keramisches Substrat hat.

10. Schaltungsanordnung nach einem der Ansprüche 1 bis 8,
**dadurch gekennzeichnet, daß**
das Filter (FI) ein Lithium-Tantalat-Substrat hat.

11. Verfahren zum Betrieb einer Schaltungsanordnung mit einem Filter mit folgenden Verfahrensschritten:
- Mischen eines Signals mit einer Empfangsfrequenz (FE) mit einem Signal mit einer ersten Oszillationsfrequenz (LO1) in einem ersten Mischer (MI1) unter Bildung eines Zwischenfrequenz-Signals (ZF),
- Filtern des Zwischenfrequenz-Signals(ZF) in einem Filter (FI), das eine Frequenzabweichung (ΔF) einer charakteristischen Frequenz von einer Sollfrequenz (FO) hat,
- Mischen des gefilterten Zwischenfrequenz-Signals(ZF) mit einem Signal mit einer zweiten Oszillationsfrequenz (LO2) in einem zweiten Mischer (MI2),
- Zuführen eines Signals, welches die Frequenzabweichung (ΔF) repräsentiert, an einen ersten Frequenzgenerator (PLL1), der das Signal mit der ersten Oszillationsfrequenz erzeugt, und an einen zweiten Frequenzgenerator (PLL2), der das Signal mit der zweiten Oszillationsfrequenz erzeugt.

12. Verfahren nach Anspruch 11,
**dadurch gekennzeichnet, daß**
das Signal mit einer ersten Oszillationsfrequenz (LO1) nach der Beziehung LO1 = FE + FO + ΔF oder nach der Beziehung LO1 = FE - FO - ΔF gebildet wird, und daß das die zweite Oszillationsfrequenz (LO2) gemäß der Beziehung LO2 = FO + ΔF gebildet wird, wobei LO1 die erste Oszillationsfrequenz (LO1), LO2 die zweite Oszillationsfrequenz (LO2), FE die Empfangsfrequenz (FE), FO die Soll-Frequenz (FO) und ΔF die Frequenzabweichung (ΔF) ist.

13. Verfahren nach Anspruch 12,
**dadurch gekennzeichnet, daß**
ein fertigungsbedingter Anteil (ΔF1) der Frequenzabweichung (ΔF) durch sukzessives Anlegen von Signalen verschiedener Frequenzen an den ersten Eingang des ersten Mischers und Messen des Amplitudenspektrums am Ausgang des zweiten Mischers (MI2) bei einer Normtemperatur gemessen wird.

14. Verfahren nach Anspruch 13,
**dadurch gekennzeichnet, daß**
ein temperaturabhängiger Anteil der Frequenzabweichung (ΔF2) durch Detektieren der Umgebungstemperatur in einem Temperatursensor (TS), Bilden eines der Umgebungstemperatur zugeordneten Temperatursignals (T) in einem Temperatursensor (TS), Zuführen des Temperatursignals (T) an einen Mikroprozessor (MP), Bilden einer dem Temperatursignal zugeordneten Frequenzabweichung (ΔF2) in einem Mikroprozessor (MP), erfolgt, und daß die Frequenzabweichung (ΔF) durch Addition der fertigungsbedingten Frequenzabweichung (ΔF1) und der temperaturbedingten Frequenzabweichung (ΔF2) berechnet wird.
